Europäisches Patentamt

European Patent Office

Office européen des brevets

(19)

(11) **EP 0 479 999 B1**

(12) **EUROPÄISCHE PATENTSCHRIFT**

(45) Veröffentlichungstag und Bekanntmachung des Hinweises auf die Patenterteilung:
**10.01.1996 Patentblatt 1996/02**

(51) Int Cl.[6]: **G01S 17/32**, G01S 17/58, G01S 7/48, H01S 3/133

(21) Anmeldenummer: **91908161.2**

(22) Anmeldetag: **16.04.1991**

(86) Internationale Anmeldenummer:
**PCT/AT91/00056**

(87) Internationale Veröffentlichungsnummer:
**WO 91/16640 (31.10.1991 Gazette 1991/25)**

(54) **EINRICHTUNG ZUR BERÜHRUNGSLOSEN GESCHWINDIGKEITS-, VERSCHIEBEWEG- UND/ODER ENTFERNUNGSMESSUNG**

DEVICE FOR THE NON-CONTACT MEASUREMENT OF SPEED, DISPLACEMENT DISTANCE AND/OR RANGE

SYSTEME POUR LA MESURE SANS CONTACT DE LA VITESSE, DU DEPLACEMENT ET/OU DE LA DISTANCE

(84) Benannte Vertragsstaaten:
**DE FR GB**

(30) Priorität: **18.04.1990 AT 906/90**

(43) Veröffentlichungstag der Anmeldung:
**15.04.1992 Patentblatt 1992/16**

(73) Patentinhaber: **Dr. Johannes Heidenhain GmbH D-83301 Traunreut (DE)**

(72) Erfinder: **TELLE, Harald D-3300 Braunschweig (DE)**

(74) Vertreter: **Torggler, Paul, Dr. et al A-6020 Innsbruck (AT)**

(56) Entgegenhaltungen:
**EP-A- 0 235 034          EP-A- 0 392 172**

- **OPTICS LETTERS. Bd. 14, Nr. 3, 1. Februar 1989, NEW YORK US Seiten 165 - 167; P.J. DE GROOT ET AL.: 'Backscatter-modulation velocimetry with an external-cavity laser diode"**
- **PATENT ABSTRACTS OF JAPAN vol. 9, no. 199 (P-380)(1922) 16. August 1985 & JP-A-60 64 284 (MATSUSHITA ) 12. April 1985**
- **APLLIED OPTICS Bd. 26, Nr. 21, 1. November 1987, Seiten 4541 - 4544; E.T.SHIMIZU: 'Directional discrimination in the self-mixing type laser doppler velocimeter '**
- **APPLIED OPTICS. Bd. 27, Nr. 2, 15. Januar 1988, NEW YORK US Seiten 302 - 305; H. TSUCHIDA ET AL.: 'Novel ring interferometer for frequency stabilization of semiconductor lasers '**
- **APPLIED PHYSICS LETTERS. Bd. 53, Nr. 11, 12. September 1988, NEW YORK US Seiten 944 - 946; L. HOLLBERG ET AL.: 'Modulatable narrow-linewidth semiconductors lasers '**
- **PROCEEDINGS OF SPIE / FIBER OPTIC AND LASER SENSORS III; vol. 566, 20 August 1985, SAN DIEGO US, pages 350 - 357; K. KYUMA ET AL.: 'Semiconductor laser and integrated optics for optical fiber sensors '**

**Beschreibung**

Die Erfindung betrifft eine Einrichtung zur berührungslosen Geschwindigkeits, Verschiebebeweg- und/oder Entfernungsmessung eines reflektierenden Meßobjektes, mit einem Laser, insbesondere Halbleiterlaser als Lichtquelle, bei dem die Lichtintensität im Laserresonator dessen optische Länge beeinflußt, mit einer Sende- und Empfangsoptik zum Richten von aus dem Halbleiterlaser stammenden Laserlicht auf das Meßobjekt und zum Rückkoppeln eines Teiles des vom Meßobjekt reflektierten Laserlichts in den Laserresonator und mit einer Detektoreinrichtung zur Erfassung und Analyse des vom Halbleiterlaser emittierten Laserlichts, das in Abhängigkeit von der Laserlicht-Rückkopplung vom Meßobjekt in den Laserresonator moduliert ist.

Es ist bereits bekannt, einen Halbleiterlaser (Laserdiode) als Empfänger bzw. als "Konverter" für das vom Meßobjekt zurückkommende Licht zu benutzen, der einzelne vom Meßobjekt in den Laserresonator zurückgekoppelte Photonen in Änderungen der Laseremissionsparameter (z.B.Intensität) umsetzt. Durch diesen Konversionsprozeß wird man in die Lage versetzt, auch bei sehr schwachen Signalen vom Meßobjekt die Meßinformation relativ großen optischen Leistungen (Bruchteile der Laser-Ausgangsleistung) entnehmen zu können, was nur äußerst geringe Anforderungen an das zu verwendende Nachweissystem stellt. In dem Artikel "Ranging and velocimetry signal generation in a backscatter-modulated laser diode" von Peter J.de Groot, Gregg M. Gallatin und Steven H. Macomber in Appl.Opt.<u>27</u>, No. 21,1988, p.4475-4480, wird eine solche Einrichtung zur berührungslosen Entfernungsmessung eines diffus streuenden Meßobjektes beschrieben. Die dabei verwendete Sende- und Empfangsoptik kann sehr einfach aufgebaut sein und erfordert im Gegensatz zu herkömmlichen Interferometern zur Längenmessung keine aufwendige Justage. Bei der bekannten Einrichtung wird ausgenutzt, daß das vom Meßobjekt in den Laserresonator zurückgekoppelte Licht zu einer Amplitudenmodulation des von der Laserdiode ausgesandten Lichtes führt. Zur Entfernungsmessung wird der Laserdiodenstrom und damit die optische Phase moduliert, und nach einer Amplitudenmodulation des Ausgangssignals der Laserdiode bei der Frequenz dieser Phasenmodulation geschaut. Ein wesentlicher Nachteil der bekannten Einrichtung besteht im jedoch darin, daß eine Geschwindigkeits- und/oder Entfernungsmessung nur bis zu einer relativ geringen Entfernung des Meßobjekts von der Laserdiode (einige Meter bei Verwendung typischer Laserdioden) möglich ist.

Aufgabe der Erfindung ist es, eine einfach zu justierende und relativ kostengünstige Einrichtung zur berührungslosen Geschwindigkeits, Verschiebebeweg- und/oder Entfernungsmessung der eingangs genannten Gattung zu schaffen, die eine erhöhte Meßempfindlichkeit aufweist und damit eine Entfernungsmessung von schwach reflektierenden, insbesondere diffus streuenden Meßobjekten in einem großen Meßbereich (vorzugsweise Bruchteile von Millimetern bis 50 m und darüber) zuläßt.

Dies wird erfindungsgemäß durch die Merkmale des Patentanspruches 1 erreicht.

Der Erfindung liegt die Erkenntnis zugrunde, daß Halbleiterlaser (Laserdioden) auf eine Rückkopplung von Laserlicht in den Laserresonator, das eine gegenüber der Emissionsfrequenz verschobene Frequenz und eine im Verhältnis zur Ausgangs-Laserleistung geringe Intensität (typischerweise $10^{-4}$ und darunter) aufweist, zu einer Frequenzmodulation des vom Halbleiterlaser emittierten Laserlichts führt. Dieser Effekt tritt allgemein bei Lasern auf, deren optische Resonatorlänge von der Lichtintensität im Resonator abhängt. Weiters liegt der Erfindung die Erkenntnis zugrunde, daß durch eine Analyse der Frequenzmodulation ein wesentlich empfindlicherer Nachweis möglich ist als dies bei einer Auswertung der bekannten rückstreusignalinduzierten Amplitudenmodulation der Fall ist. Damit ist auch bei schwächer, insbesondere diffus reflektierenden Meßobjekten (sog."non-cooperative targets) ohne eigenen optischen Reflektor bzw. über größere Entfernungen eine genaue Entfernungs- und/oder Geschwindigkeitsmessung möglich, wobei ein Dauerstrichlaser mit geringer Leistung (beispielsweise im 10 mW-Bereich) zum Einsatz kommen kann, was im Hinblick auf eine Augengefährdung und Materialbelastung des Objektes vorteilhaft ist. Mit einer herkömmlichen Standard-Laserdiode ist beispielsweise eine Geschwindigkeits- und/oder Entfernungsmessung mit einer Entfernung des Meßobjekts von der Laserdiode von bis zu über 50 m mit hoher Genauigkeit möglich. Der optische Aufbau ist dabei äußerst einfach und justierunempfindlich. Die Sende- und Empfangsoptik kann im einfachsten Fall aus einer Linse oder einer einfachen Linsenanordnung bestehen, die den aus dem Halbleiterlaser (Laserdiode) austretenden Lichtstrahl kollimiert bzw. fokussiert. Über ein und dieselbe Linse bzw. Linsenanordnung kann die Rückkopplung von Licht, das vom Meßobjekt zurückgestreut wird, in den Laserresonator des Halbleiterlasers erfolgen.

Laserdioden reagieren aufgrund ihrer hohen optischen Verstärkung, den damit verbundenen relativ geringen Reflexionskoeffizienten der den Laserresonator begrenzenden Spiegelflächen und der damit großen Eintrittswahrscheinlichkeit für rückgestreute Photonen sehr empfindlich auf zurückgekoppeltes Licht. Je nachdem, ob das zurückgestreute Photon in Phase mit dem Laserfeld im Resonator ist oder nicht, kommt es zu einer momentanen Verstärkung bzw. Abschwächung des Laserfelds. Die Balance zwischen Verstärkung und Verlusten sorgt dann dafür, daß die Photonenzahl (Intensität) wieder auf den Gleichgewichtswert zurückpendelt. Bei einer Laserdiode passiert das innerhalb von weniger als $10^{-9}$ Sekunden. Durch diese schnelle Zurückregelung ist dieser Effekt in der Amplitude bzw. Intensität nur schwer zu beobachten. Bei den Halbleiterlaser (Laserdioden) hängt nun die Ladungsträgerdichte und damit die Emissionsfrequenz sehr empfindlich von der Lichtintensität im Resonator ab. Die Auslenkung in der Photonenzahl (hervorgerufen durch vom Objekt zurückgestreute Photonen) ändert daher kurzfristig die Frequenz und damit langfristig, wenn die Strahlung wieder im Gleichgewicht, die Phase der emittierten Welle. Ist die Frequenz des in den Laserresonator zurückgekoppelten Lichts beispielsweise aufgrund des Dopplereffektes eines bewegten Objektes gegenüber der Emissionsfrequenz geringfügig verschoben, so ändert sich die relative Phasenlage zwischen dem Laserfeld im Resonator und dem zurückgekoppelten Licht gerade im Takt mit der Differenzfrequenz zwischen Emissionsfrequenz und rückgekoppelter Frequenz. Dies führt aufgrund der oben erwähnten Eigenschaften von Halbleiterlasern (Laserdioden) zu einer Phasen- bzw. Frequenzmodulation im Takt der Differenzfrequenz (bei bewegten Objekten ist dies gerade die Dopplerverschiebung). Wegen der raschen Reaktion von Laserdioden auf Störungen von außen sind diese auch bei Differenzfrequenzen im Megaherzbereich und darüber in der Lage immer praktisch instantan zu reagieren (wohleingeschwungener, quasistationärer Fall), womit sich in der Modulationsfrequenz der frequenzmodulierten emittierten Strahlung genau die Differenzfrequenz zwischen emittierter Trägerfrequenz und rückgekoppelter Frequenz widerspiegelt.

Für typische Halbleiterlaser (Laserdioden) ist nun die für die Amplitudenmodulation verantwortliche relative Änderung der Amplitude wesentlich geringer als der Phasenhub, zu dem die erfindungsgemäß detektierte Phasen- bzw. Frequenzmodulation proportional ist. Damit ergibt sich eine in der Größenordnung von zehn- bis hundertfach höhere Empfindlichkeit bei einer Analyse der Frequenzmodulation, was bei gleicher Sendeleistung eine entsprechend höhere Reichweite der Einrichtung bzw. ein entsprechend besseres Ansprechen bei weniger gut reflektierenden Meßobjekten mit sich bringt. Das erzielte Signal/Rauschverhältnis ist bei der Detektion der Frequenzmodulation hervorragend, wobei man die Schrotrauschbegrenzung zumindest näherungsweise erreicht. Trotz der hohen Meßempfindlichkeit ist die erfindungsgemäße Einrichtung unempfindlich auf Fremdlichteinfall und kann daher auch im Freien problemlos eingesetzt werden.

Die Detektion der rückstreusignalinduzierten Frequenzfluktuationen (Ermittlung der Modulationsfrequenz) stellt gegenüber einer einfachen Ermittlung einer Amplitudenmodulation zwar zunächst einen höheren Aufwand dar, da sich die Frequenzmodulation in der von Photodetektoren erfaßbaren Intensität nicht direkt widerspiegelt. Es sind zusätzliche Einrichtungen, etwa ein im folgenden noch näher erläuterter Diskriminator nötig, die beispielsweise die Frequenzmodulation zunächst in eine Amplitudenmodulation umwandeln, welche dann von Photodetektoren leicht erfaßbar ist. Diese zusätzlichen Einrichtungen bringen aber auch einen wichtigen Vorteil, da man noch einen zusätzlichen Freiheitsgrad (nämlich z.B. die Diskriminatorsteilheit) bei der Auslegung der Einrichtung hat. Damit läßt sich die Einrichtung erheblich besser an spezifische Meßaufgaben anpassen.

Die erfindungsgemäße Einrichtung erfaßt - wie bereits erwähnt - im Gegensatz zur bekannten Einrichtung nicht die Amplitudenmodulation, sondern die rückstreusignal-induzierte Frequenzmodulation des Laserlichtes, das heißt, sie stellt ein elektrisches Signal bereit, das die Frequenzmodulations-Frequenz widerspiegelt. Dieses elektrische Signal läßt sich dann in einer angeschlossenen bzw. integrierten elektronischen Auswertschaltung der photoelektrischen Detektoreinrichtung weiterverarbeiten, um die gesuchten Größen, Entfernung und/oder Geschwindigkeit des Meßobjektes ermitteln zu können. Bei dieser elektronischen Auswertung können natürlich selbstverständlich auch weitere Parameter, wie die Brechzahl des Umgebungsmediums, die Treiberfrequenz eines noch zu beschreibenden akustooptischen Modulators oder eine gezielte Modulationsfrequenz der Sendefrequenz der Laserdiode mit einbezogen werden. Die Auswertung kann prinzipiell sowohl in der Zeit- als auch in der Frequenzdomäne erfolgen. Eine Auswertung in der Zeitdomäne wird im allgemeinen auf die Anwendung von Korrelationstechniken hinauslaufen, mit entsprechendem Bedarf an Rechenkapazität, wobei auch die FFT(fast fourier transformation) auch zu diesen Korrelationstechniken zählen soll. Die Auswertung in der Frequenzdomäne kann entweder mit einem Spektrumanalysator (Scanning-Filter-Spektrum-Analysator) oder mit einer Filterbank erfolgen. Während sich die Korrelationstechniken insbesondere bei niedrigen Frequenzen eignen, zeichnen sich die Filterbank bei hohem Datendurchsatz und der Spektrumanalysator beim nutzbaren Dynamikumfang aus.

Die erfindungsgemäße Einrichtung eignet sich zunächst zur Bestimmung der Geschwindigkeit des Meßobjektes, wobei die in Laserstrahl richtung vorhandene Geschwindigkeitskomponente ermittel wird. Die Auswertung erfolgt über die bekannte Dopplerformel, welche den Zusammenhang zwischen Geschwindigkeit und Frequenzverschiebung wiedergibt, die sich in der erfaßten Modulationsfrequenz widerspiegelt. Der typische erfaßbare Geschwindigkeitsbereich liegt etwa zwischen Millimeter/sec bis einige 10m/sec.

Durch Zählen der Modulationsfrequenz ist auch eine Verschiebewegbestimmung des Meßobjektes möglich, wobei man insbesondere bei optisch polierten Meßobjekten (z.B.Spiegeln) interferometrische Genauigkeit erzielt.

Moduliert man die Sendefrequenz der Laserdiode, so ist auch eine absolute Entfernungsmessung möglich (chirp-Radar). Eine solche Modulation ist beispielsweise dadurch möglich, daß der Resonator, auf den die Laserfrequenz stabilisiert ist, etwa über piezoelektrische Elemente gezielt moduliert wird. Die gesuchte Entfernung d ergibt sich dann bei gegebener Sende-Modulationsfrequenz $f_{mod}$ und gegebenen Frequenzhub $\Delta v$ zu

$$n.d = \frac{c}{\Delta \nu} \frac{\Delta f}{f_{mod}}$$

wobei n die Brechzahl des Umgebungsmediums, c die Vakuum-Lichtgeschwindigkeit ist und $\Delta f$ die ermittelte Modulationsfrequenz ist. Typische erfaßbare Abstände liegen im Bereich zwischen Zehntel Millimeter und etwa 100m.

Zunächst ist es aber eine wesentliche Aufgabe der erfindungsgemäßen Einrichtung zur Erfassung der Modulationsfrequenz, ein entsprechendes elektrisches Signal bereitzustellen. Da sich - wie erwähnt - die Frequenzmodulation mit Photodetektoren nicht direkt erfassen läßt, muß man im allgemeinen dafür Sorge tragen, diese Frequenzmodulation zunächst in eine für Photodetektoren erfaßbare Amplitudenmodulation umzuwandeln. Eine frequenzmodulierte Schwingung läßt sich in bekannter Weise als Überlagerung von einer zentralen Trägerfrequenz (Mittenfrequenz) und zwei intensitätsgleichen, phasenverschobenen Seitenbändern darstellen, die von der Trägerfrequenz einen der Modulationsfrequenz entsprechenden Abstand aufweisen. Stört man in einem hochfrequenzselektiven Prozeß die "Balance" zwischen Trägerfrequenz und den beiden Seitenbändern der ursprünglich rein frequenzmodulierten Schwingung, indem man beispielsweise die Trägerfrequenz gegenüber den Seitenbändern phasenverschiebt oder eines der beiden Seitenbänder wegnimmt, so tritt eine der Modulationsfrequenz entsprechende Amplitudenmodulation auf, die sich mit einem Photodetektor erfassen läßt.

Gemäß einer bevorzugten Ausführungsform der Erfindung ist dazu vorgesehen, daß die Einrichtung zur Erfassung der Modulationsfrequenz eine optische Anordnung, vorzugsweise einen optischen Frequenzdiskriminator, zur Erzeugung einer mit der Modulationsfrequenz der Frequenzmodulation amplitudenmodulierten Ausgangsstrahlung aufweist, welche von mindestens einem Photodetektor detektiert wird, wobei es besonders vorteilhaft scheint, wenn der Frequenzdiskriminator ein vorzugsweise in Reflexion betriebener optischer Resonator, (vorzugsweise Ringresonator ist), dessen Resonanzfrequenz (Resonanzmittenfrequenz) knapp neben der Trägerfrequenz des frequenzmodulierten Laserlichts liegt.

Die relative Lage von Resonanzfrequenz des Resonators und Trägerfrequenz des frequenzmodulierten Laserlichtes kann entweder dadurch festgelegt werden, daß man die Resonanzfrequenz auf die Trägerfrequenz des Laserlichtes oder umgekehrt die Trägerfrequenz des Laserlichtes auf die Resonanzfrequenz des Resonators abstimmt, wobei die letztere Variante als die günstigere erscheint. Diese Regelung bzw. Stabilisierung auf bzw. kanpp neben die Resonanzfrequenz kann durch eine im folgenden noch näher erläuterte elektronische Regeleinrichtung erfolgen.

Der als in Reflexion betriebener optischer Resonator aufgebaute Frequenzdiskriminator reflektiert an seinem Eingangsspiegel die Trägerfrequenz des frequenzmodulierten Lichts in der Nähe einer Resonanz mit einem anderen Phasensprung als die beiden Seitenbänder. Dadurch kommt es zu einer Amplitudenmodulation, die von einer schnellen Photodiode samt angeschlossenem Verstärker in ein elektrisches Signal umwandelbar ist. Dieses Signal kann dann beispielsweise in einem Spektrumsanalysator analysiert und in einer Auswertschalung weiterverarbeitet bzw. entsprechend angezeigt werden. Der in Reflexion betriebene Ringresonator hat den Vorteil, daß auch größere Modulationsfrequenzen (und damit auch größere Geschwindigkeiten des Meßobjektes) erfaßbar sind. Außerdem hat der Ringresonator gegenüber Stehwellenresonatoren (beispielsweise Etalons) den Vorteil, daß es praktisch keine störenden optischen Rückkoppelungen gibt, die sich nur mit aufwendigen Mitteln, beispielsweise Faraday-Isolatoren abblocken lassen würden.

Ein bevorzugtes Ausführungsbeispiel der Erfindung besteht darin, daß die erfindungsgemäße Einrichtung eine frequenzselektive optische Anordnung zur Erzeugung mindestens eines die frequenzmäßige Lage der momentanen Frequenz des Laserlichts bezüglich einer Referenzfrequenz widerspiegelnden optischen Regelsignals, mindestens einen Photodetektor zur Umsetzung des optischen Regelsignals in ein elektrisches Regelsignal und eine elektronische Regeleinrichtung aufweist, die in Abhängigkeit von diesem elektrischen Regelsignal die Trägerfrequenz des Halbleiterlasers auf die Referenzfrequenz regelt bzw. stabilisiert. Die frequenzselektive optische Anordnung wird vorzugsweise von einem in Transmission betriebenen Ringresonator gebildet, über dessen Resonanzfrequenz(en) die Referenzfrequenz festgelegt wird, auf die die Trägerfrequenz des Halbleiterlasers elektronisch stabilisiert wird. Solche an sich bekannten schnellen elektronischen Regelungen erlauben beispielsweise über die Regelung des Injektionsstroms der Laserdiode eine einfache Frequenzregelung, wobei die Emissionslinienbreite der Sendefrequenz durch diese elektronische Stabilisierung wesentlich verringert und damit das Auflösungsvermögen der Einrichtung beträchtlich erhöht wird.

Der oben erwähnte optische Frequenzdiskriminator und die frequenzselektive optische Anordnung für die elektronische Regelung können von ein und denselben optischen Bauteilen gebildet sein. Beispielsweise kann das von einem speziellen, im folgenden noch näher beschriebenen Ringresonator transmitierte Signal für die elektronische Regelung herangezogen werden, während das reflektierte Signal zur Ermittlung der Modulationsfrequenz verwendet wird.

Die genannte schnelle elektronische Stabilisierung bzw. Regelung der Sendefrequenz des Halbleiterlasers führt zu einer Verringerung der Linienbreite der Sendefrequenz und damit zu einer Erhöhung der Kohärenzlänge. Weiters erlaubt diese elektronische Regelung auf elegante Weise eine automatische Kompensation von Schwankungen der Brechzahl des Umgebungsmediums, welche ansonsten das Meßergebnis beeinflußen würden. Dazu ist erfindungsgemäß vorgesehen, daß die frequenzselektive optische Anordnung mit der Umgebungsluft kommuniziert, sodaß die Referenzfrequenz automatisch in Abhängigkeit von der Brechzahl der Umgebungsluft variiert. Regelt man die Trägerfrequenz des Halbleiterlasers (Laserdiode) auf diese Referenzfrequenz, so bleibt die im Umgebungsmedium (meist Luft) vorhandene Luftwellenlänge vorteilhafterweise konstant. Die frequenzselektive optische Anordnung kann in einem solchen Fall statisch aufgebaut sein, das heißt beispielsweise bei einem Ringresonator, daß die Lage der beteiligten Spiegel räumlich zueinander festliegt. Unter einem "Kommunizieren mit der Umgebungsluft" ist gemeint, daß Umgebungsmediun sich im Resonatorraum zwischen den Spiegeln befindet, sodaß die dort vorhandene Brechzahl mit der außerhalb vorhandenen Brechzahl übereinstimmt.

Bei der Erfassung der Modulationsfrequenz eignet sich je nach Bereich dieser Modulationsfrequenz (das heißt bei einer Geschwindigkeitsmessung je nach Geschwindigkeit des Meßobjektes) unterschiedliche Auswertverfahren, die allerdings nebeneinander in ein und derselben Einrichtung verwirklicht sein können, sodaß der gesamte Geschwindigkeitsbereich bzw. Entfernungsbereich erfaßbar ist.

Bei geringen Modulationsfrequenzen (typischerweise im 10 MHz-Bereich und darunter) kann man das Meßsignal direkt dem elektrischen Regelsignal der elektronischen Regelung zur Stabilisierung der Laserdioden-Trägerfrequenz entnehmen. In diesem Frequenzbereich ist die elektronische Regeleinrichtung noch schnell genug, um der Modulationsfrequenz folgen zu können. Das elektrische Regelsignal spiegelt also genau die Modulationsfrequenz und damit beispielsweise die Geschwindigkeit des Meßobjektes wider. Die Bewegungsrichtung des Meßobjektes kann in diesem Fall durch eine Modulation der Resonatorfrequenz erkannt werden, auf die die Trägerfrequenz des Halbleiterlasers elektronisch stabilisiert ist. Die Verschiebung der Frequenz des rückgestreuten Lichtes relativ zur momentanen Laserfrequenz hängt nämlich davon ab, ob sich die modulierte Laserfrequenz auf die Doppler-verschobene Frequenz zu- oder von ihr fortbewegt. Mit einem phasenempfindlichen Nachweis beispielsweise mit einem Lock-in-Verstärker kann man dann die Bewegungsrichtung ermitteln.

Für höhere Geschwindigkeiten (größere Entfernungen) und den damit verknüpften höheren Modulationsfrequenzen (typischerweise einige 10 MHz und darüber) läßt sich die Modulationsfrequenz beispielsweise aus dem von einem optischen Ringresonator reflektierten Signal ermitteln, das von einem Photodetektor erfaßt und dann beispielsweise von einem Spektrumanalysator analysiert wird. Verwendet man bei einer solchen Auswertung durch einen optischen Frequenzdiskriminator die oben erwähnte elektronische Regelung zur Stabilisierung der Laserdioden-Trägerfrequenz, so muß man dafür Sorge tragen, daß es zu keinen störenden Wechselwirkungen mit dieser elektronischen Regelung kommt. Im einfachsten Fall läßt sich dies gemäß einer bevorzugten Ausführungsform der Erfindung dadurch erzielen, daß das aus dem Halbleiterlaser stammende Laserlicht zwischen Halbleiterlaser und Meßobjekt durch eine Frequenzverschiebeeinrichtung geführt ist. Durch eine solche Frequenzverschiebeeinrichtung, die beispielsweise von einem sowohl auf dem Hin- als auch auf dem Rückweg durchlaufenen akusto-optischen Modulator gebildet sein kann, liegt die Modulationsfrequenz oberhalb der Grenzfrequenz der elektronischen Regelung, womit die gewünschte Entkopplung erzielt ist. Der vom akusto-optischen Modulator hervorgerufene Frequenzversatz kann bei einmaligem Durchlauf günstigerweise zwischen 10 und 100 MHz liegen (bei zweifachem Durchlauf entsprechend doppelt soviel). Der akusto-optische Modulator stellt weiters ein Abschwächglied dar, das zu hohe in den Laserresonator rückgekoppelte Leistungen verhindert. Alternativ oder zusätzlich kann vorgesehen sein, daß ein Strahlengang zwischen dem Halbleiterlaser und dem Meßobjekt ein gegebenenfalls geregeltes Abschwächglied angeordnet ist, das sicherstellt, daß weniger als $10^{-3}$ der Ausgangsleistung des Halbleiterlasers in diesen zurückgekoppelt wird.

Neben den genannten Vorteilen weist die Frequenzverschiebeeinrichtung (akusto-optischer Modulator) vor allem den Vorteil auf, daß er auf einfache Weise eine Erkennung der Bewegungsrichtung des Meßobjektes erlaubt. Bei ruhendem Meßobjekt liegen die Seitenbänder des frequenzmodulierten Laserlichtes gerade in einem Abstand, der dem durch den akusto-optischen Modulator hervorgerufenen Frequenzversatz entspricht. Bewegt sich nun das Meßobjekt auf die erfindungsgemäße Einrichtung zu, so liegen die Seitenbänder aufgrund des Doppler-Effekts weiter von der mittleren Trägerfrequenz entfernt. Bewegt sich das Meßobjekt von der erfindungsgemäßen Einrichtung weg, so kommt es zu einer Verringerung der effektiven Differenzfrequenz zwischen Trägerfrequenz und rückgekoppelter Frequenz, sodaß die Seitenbänder nun näher bei der Trägerfrequenz liegen. Die von der erfindungsgemäßen Einrichtung erfaßte Lage der Seitenbänder (entsprechend der Frequenzmodulations-Frequenz der frequenzmodulierten Laserstrahlung) spiegelt also auch die Bewegungsrichtung des Meßobjektes wider.

Weitere Vorteile und Einzelheiten der Erfindung werden in der folgenden Figurenbeschreibung näher erläutert.

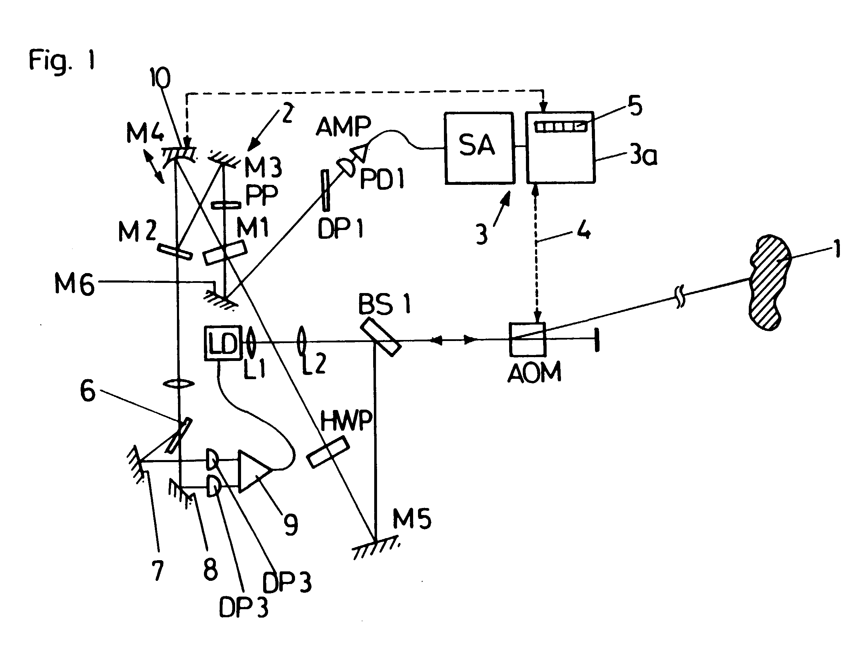

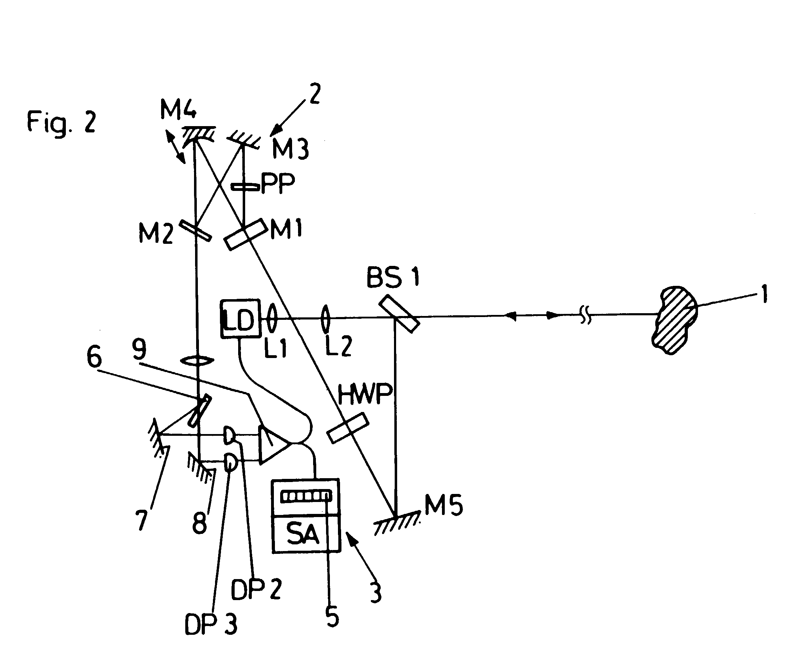

Es zeigen die Fig. 1 und die Fig. 2 jeweils ein Ausführungsbeispiel der erfindungsgemäßen Einrichtung in schematischer Darstellung.

Die in Fig. 1 dargestellte Einrichtung zur berührungslosen Geschwindigkeits- und/oder Entfernungsmessung weist eine Laserdiode LD als Laserlichtquelle auf. Uber eine Sende- und Empfangsoptik, die beim vorliegenden Ausführungsbeispiel aus zwei Linsen L1 und L2 besteht, gelangt das von der Laserdiode emittierte Licht über einen akusto-optischen Modulator AOM auf das Meßobjekt. Ein Teil des vom Meßobjekt 1 reflektierten Lichts gelangt auf demselben Weg wieder in den Laserresonator der Laserdiode LD zurück. Der akusto-optische Modulator ruft bei einmaligem Durchlauf beispielsweise einen Frequenzversatz von 80 MHZ und entsprechend bei zweimaligem Durchlauf von 160 MHZ hervor. Bei ruhendem Meßobjekt 1 gelangt also Laserlicht in den Laserresonator zurück, das gegenüber der Sendefrequenz (Trägerfrequenz) um 160 MHZ Frequenz verschoben ist. Dies führt zu einer Frequenzmodulation des von den Laserdioden emittierten Lichtes, wobei die Modulationsfrequenz gerade der genannten Differenzfrequenz von 160 MHZ (bei ruhendem Meßobjekt 1) entspricht.

Bewegt sich nun das Meßobjekt 1, so kommt es aufgrund des Doppeleffekts zu einer Änderung dieses vom akusto-optischen Modulator hervorgerufenen Frequenzversatzes, wobei die Differenz zwischen Trägerfrequenz und rückgekoppelter Frequenz bei auf die Einrichtung zubewegtem Meßobjekt steigt und bei von der Einrichtung wegbewegtem Meßobjekt sinkt. Die Modulationsfrequenz der frequenzmodulierten Strahlung der Laserdiode spiegelt also neben der Geschwindigkeit des Meßobjekts auch die Bewegungsrichtung wider. Erfindungsgemäß ist eine Einrichtung zur Erfassung der Modulationsfrequenz des vom Halbleiterlaser (Laserdiode LD) emittierten, frequenzmodulierten Laserlichts vorgesehen. Der wesentliche optische Bestandteil dieser Einrichtung ist der optische Frequenzdiskriminator 2, der beim vorliegenden Ausführungsbeispiel ein in Reflexion betriebener Ringresonator ist. Beim vorliegenden Ausführungsbeispiel ist die Resonanzfrequenz des Ringresonators 2 leicht polarisationsabhängig, das heißt die Resonanzfrequenz für eine Polarisation des Laserlichtes liegt knapp neben der Resonanzfrequenz für die andere, darauf senkrechte Polarisation. Es gibt also (für zwei unterschiedliche Polarisationen) zwei Resonanzfrequenzen. Die Resonanzmittenfrequenz der einen Polarisation liegt dabei so knapp bei der Resonanzmittenfrequenz der anderen Polarisation, daß die beiden Resonanzmittenfrequenzen jeweils innerhalb der Resonanzlinienbreite der jeweils anderen Polarisation liegen ("teilweise überlappende Resonanzkurven"). Die Trägerfrequenz des frequenzmodulierten Laserlichtes liegt zwischen den beiden genannten Resonanzmittenfrequenzen. Der Ringresonator weist vier dielektrische Spiegel M1, M2, M3 und M4 auf. Die Diskriminatorkennlinienbreite (Resonanzlinienbreite) liegt im Bereich von einigen 10 MHz.

Das aus der Laserdiode austretende, frequenzmodulierte Licht gelangt über einen Strahlteiler BS 1, einen Spiegel M5 und eine Halbwellenplatte HWP über den Einkoppelspiegel M1 in diesen Ringresonator. Wesentlich ist nun, daß dieser in Reflexion betriebene Ringresonator die Trägerfrequenz einerseits und die beiden Seitenbänder der frequenzmodulierten Strahlung andererseits mit einem unterschiedlichen Phasensprung reflektiert. Diese Störung der "Balance" zwischen Trägerfrequenz und den beiden Seitenbändern führt zu einer Amplitudenmodulation im reflektierten Licht, deren Modulationsfrequenz gerade der Frequenzmodulationsfrequenz entspricht. Diese Amplitudenmodulation läßt sich nach Reflexion am Spiegel M6 und nach Durchgang der Strahlung durch den dielektrischen Polarisator DP1 durch die schnelle PIN-Photodiode PD1 in ein elektrisches Signal umwandeln, das diese Modulationsfrequenz widerspiegelt. Über einen Universalverstärker AMP gelangt dieses Signal in eine Auswerteinrichtung 3, die einen Spektrumanalysator SA aufweist. An diesen Spektrumanalysator kann eine Rechen- und Auswerteinrichtung 3a angeschlossen sein, die aus der ermittelten Modulationsfrequenz und weiteren Parametern (wie beispielsweise der über die Leitung 4 zugeführten Treiberfrequenz des akusto-optischen Modulators) gemäß der bekannten Doppler-Formel die Geschwindigkeit des Meßobjektes 1 ermitteln und über die Anzeige 5 anzeigen kann.

Bei festgehaltener Trägerfrequenz der Laserdiode LD arbeitet die vorliegende Einrichtung der Fig. 1 als Geschwindigkeitsmesser. Zur präzisen Festhaltung der Trägerfrequenz der Laserdiode ist eine elektronische Regelung vorgesehen, die im folgenden näher beschrieben wird. Der Ringresonator 2 stellt eine frequenzselektive optische Anordnung dar, die dazu geeignet ist, ein optisches Regelsignal abzugeben, das die frequenzmäßige Lage der momentanen Frequenz des Laserlichts bezüglich einer durch die Resonanzfrequenz(en) bestimmten Referenzfrequenz widerzugeben. Dieses optische Regelsignal tritt bei dem in Transmission betriebenen Resonator über den Spiegel M2 aus. Das optische Regelsignal wird von Photodetektoren DP2 und DP3 in jeweils ein elektrisches Regelsignal umgewandelt. Die elektronische Regeleinrichtung 9 regelt nun in Abhängigkeit von diesen elektrischen Regelsignalen die Trägerfrequenz der Laserdiode LD und stabilisert diese damit auf eine Referenzfrequenz, die zwischen den beiden vom Ringresonator 2 vorgegebenen, polarisationsabhängigen Resonanzfrequenzen liegt. Die planparallele Glasplatte PP ist durch seitlichen Druck leicht doppelbrechend. Dadurch kann die Polarisationsabhängigkeit der Resonatormoden noch fein abgestimmt werden. Im Polarisationsstrahlteiler 6 erfolgt eine Zerlegung nach zwei aufeinander senkrechten Polarisationen, die über Spiegel 7 und 8 auf die bereits genannten Photodetektoren DP2, DP3 gelangen. Die elektrische Regeleinrichtung weist im wesentlichen einen Differenzbilder zwischen den beiden Photodetektorsignalen auf. Sind die beiden Resonanzkurven so verschoben, daß die Resonanzmittenfrequenzen eine volle Halbwertsbreite auseinanderliegen, so kommt es durch die Subtraktion der beiden Resonanzkurven im Differenzbilder zu einer "Diskriminator-Kennlinie", nach der eine eindeutige Regelung in beiden Richtungen möglich ist.

Wie aus Fig. 1 ersichtlich ist, erfüllt der spezielle Ringresonator also in Reflexion die Funktion eines Frequenzdiskriminators zur Ermittlung der Modulationsfrequenz und in Transmission die Funktion einer frequenzselektiven optischen Anordnung zur Bereitstellung eines optischen Regelsignals, das eine Stabilisierung der Trägerfrequenz der Laserdiode auf eine zwischen den beiden polarisationsabhängigen Resonanzfrequenzen des Ringresonators liegende Referenzfrequenz erlaubt. Grundsätzlich wäre es auch denkbar, mit nur einer Resonanzkurve zu arbeiten und dort eine Flankenstabilisierung vorzunehmen, um die Trägerfrequenz auf einen neben der Resonatormittenfrequenz liegenden Wert zu stabilisieren.

Befindet sich zwischen den Spiegeln M1, M2, M3 und M4 des Ringresonators 2 das Umgebungsmedium (meist Luft), so ändert (ändern) sich die Resonanzfrequenz(en) und damit die Referenzfrequenz automatisch mit der variierenden Brechzahl des Umgebungsmediums. Damit ändert sich die Trägerfrequenz der Laserdiode, die ja gerade auf diese Referenzfrequenz über die elektronische Regelung stabilisiert ist, gerade so, daß die im Umgebungsmedium vorhandene Wellenlänge (Luftwellenlänge) konstant bleibt. Schwankungen der Umweltbedingungen werden so automatisch kompensiert.

Um die Entfernung des Meßobjektes 1 von der erfindungsgemäßen Einrichtung zu ermitteln, kann die Sendefrequenz der Laserdiode LD vorzugsweise periodisch (beispielsweise zeitlich sägezahnförmig im kHz-Bereich) moduliert werden, wobei der Frequenzhub beispielsweise 100 GHz beträgt. Die von der erfindungsgemäßen Einrichtung ermittelte Modulationsfrequenz hängt dann in an sich bekannter Weise (Chirp-Radar) von der Entfernung des Meßobjektes 1 ab. Die Modulation der Sendefrequenz läßt sich auf elegante Weise dadurch realisieren, daß die Referenzfrequenz, auf die die Trägerfrequenz der Laserdiode elektronisch stabilisiert ist, periodisch verändert wird. Dies ist beispielsweise dadurch möglich, daß der Spiegel M4 des Ringresonators 2 durch ein piezoelektrisches Element 10 periodisch verstellt wird. Die Treiberfrequenz des piezoelektrischen Elementes 10 wird vorteilhaft der Auswerteinrichtung 3 zugeführt.

Abschließend wäre zu dem in Fig. 1 gezeigten Ausführungsbeispiel noch zu erwähnen, daß die relativ einfache Sende- und Empfangsoptik (L1, L2) einen leicht konvergenten Meßstrahl erzeugt, in dessen Zwischenfokus der akusto-optische Modulator AOM angeordnet ist.

In Fig. 2 ist ein vereinfachtes Ausführungsbeispiel dargestellt, das sich insbesondere zur Messung von langsameren Geschwindigkeiten (bzw. geringeren Entfernungen) eignet. Der optische Aufbau entspricht im wesentlichen den der Fig. 1. Es ist lediglich kein akusto-optischer Modulator AOM vorgesehen. Dadurch stimmt bei ruhendem Objekt der die Sendefrequenz der Laserdiode LD mit der Frequenz des zurückgekoppelten Lichts überein. Bewegt sich das Meßobjekt 1, so tritt eine Differenzfrequenz zwischen Sendefrequenz und rückgekoppelter Frequenz gemäß dem bekannten Doppler-Effekt auf. Bei abgeschalteter Regelung 9 führt dies direkt zu einer Frequenzmodulation des von der Laserdiode LD emittierten Lichtes, die sich im optischen Regelsignal, welches über den Spiegel M2 aus dem Ringresonator austritt, widerspiegelt. Bei eingeschalteter elektronischer Regelung 9 versucht diese die rückstrahlsignal-induzierte Frequenzmodulation herauszuregeln, wobei sich die Modulationsfrequenz im elektrischen Regelsignal widerspiegelt. Eine Auswertschaltung 3, die einen Spektrumanalysator SA und eine Anzeige 5 aufweist, kann daher aus diesem elektrischen Regelsignal die Geschwindigkeit des Meßobjektes 1 ermitteln.

Die Erfindung ist selbstverständlich nicht auf die dargestellten Ausführungsbeispiele beschränkt. Beispielsweise kann ein zusätzliches (nicht dargestelltes) Abschwächglied im Strahlengang vorgesehen sein, um leistungsmäßig zu große Rückkopplungen (über $10^{-3}$ der Ausgangsleistung der Laserdiode) zu vermeiden. Neben der elektronischen Stabilisierung bzw. Regelung der Trägerfrequenz der Laserdiode besteht grundsätzlich auch die Möglichkeit einer Stabilisierung durch eine optische Rückkopplung (beispielsweise aus einem Etalon).

**Patentansprüche**

1. Einrichtung zur berührungslosen Geschwindigkeits-, Verschiebeweg- und/oder Entfernungsmessung eines reflektierenden Meßobjektes, mit einem Laser (LD), insbesondere Halbleiterlaser als Lichtquelle, bei dem die Lichtintensität im Laserresonator dessen optische Länge beeinflußt, mit einer Sende- und Empfangsoptik (L1, L2) zum Richten von aus dem Laser (LD) stammendem Laserlicht auf das Meßobjekt (1) und zum Rückkoppeln eines Teiles des vom Meßobjekt (1) reflektierten Laserlichts in den Laserresonator und mit einer Detektoreinrichtung zur Erfassung und Analyse des vom Laser (LD) emittierten Laserlichts, das in Abhängigkeit von der Laserlicht-Rückkoppelung vom Meßobjekt (1) in den Laserresonator moduliert ist, dadurch gekennzeichnet, daß die Detektoreinrichtung wenigstens eine Einrichtung (2, PD1, 3) zur Erfassung der Modulationsfrequenz der Frequenzmodulation des vom Laser (LD) emittierten, durch das Rückstreusignal frequenzmodulierten Laserlichts aufweist.

2. Einrichtung nach Anspruch 1, dadurch gekennzeichnet, daß die Einrichtung (2, PD1, 3) zur Erfassung der Modulationsfrequenz eine optische Anordnung, vorzugsweise einen optischen Frequenzdiskriminator (2), zur Erzeugung einer mit der Modulationsfrequenz der Frequenzmodulation amplitudenmodulierten Ausgangsstrahlung aufweist, welche von mindestens einem Photodetektor (PD1) detektiert wird.

3. Einrichtung nach Anspruch 2, dadurch gekennzeichnet, daß der Frequenzdiskriminator (2) ein vorzugsweise in Reflexion betriebener optischer Resonator, insbesondere Ringresonator (M1,M2,M3,M4) ist, wobei die Trägerfrequenz des frequenzmodulierten Laserlichts innerhalb der Resonanzlinienbreite, vorzugsweise neben der Resonanzmittenfrequenz einer Resonanz des Ringresonators liegt.

4. Einrichtung nach Anspruch 3, dadurch gekennzeichnet, daß der Resonator dielektrische Spiegel (M1,M2,M3,M4) aufweist.

5. Einrichtung nach einem der Ansprüche 2 bis 4, dadurch gekennzeichnet, daß die Diskriminatorkennlinienbreite (Resonanzlinienbreite) im 10-1000 MHz-Bereich liegt.

6. Einrichtung nach einem der Ansprüche 1 bis 5, dadurch gekennzeichnet, daß sie eine frequenzselektive optische Anordnung (M1,M2,M3,M4) zur Erzeugung mindestens eines die momentane Lage der Frequenz des Laserlichts bezüglich einer Referenzfrequenz widerspiegelnden optischen Regelsignals, mindestens einen Photodetektor (DP2, DP3) zur Umsetzung des optischen Regelsignals in ein elektrisches Regelsignal und eine elektronische Regeleinrichtung (9) aufweist, die in Abhängigkeit von diesem elektrischen Regelsignal die Trägerfrequenz des Halbleiterlasers (LD) auf die Referenzfrequenz regelt bzw. stabilisiert.

7. Einrichtung nach Anspruch 6, dadurch gekennzeichnet, daß die frequenzselektive optische Anordnung ein optischer Resonator, vorzugsweise ein in Transmission betriebener Ringresonator (M1,M2,M3,M4) ist, dessen Resonanzfrequenz die Referenzfrequenz definiert.

8. Einrichtung nach Anspruch 7, dadurch gekennzeichnet, daß die Resonanzmittelfrequenz des Resonators (M1,M2,M3,M4) von der Polarisation des Lichtes abhängt, wobei die Resonanzmittelfrequenzen für zwei aufeinander senkrechte Polarisationen nebeneinander und jeweils innerhalb der Resonanzlinienbreite der jeweils anderen Polarisation liegen, und daß dem Resonator (M1,M2,M3,M4) ein Polarisationsstrahlteiler (6), ein Strahlteiler mit nachgeschalteten Polarisatoren oder dgl. zur Zerlegung des optischen Regelsignals in zwei Teilstrahlen verschiedener Polarisation nachgeschaltet ist, wobei die Teilstrahlen von gesonderten Photodetektoren (DP2,DP3) erfaßt werden.

9. Einrichtung nach Anspruch 8, dadurch gekennzeichnet, daß die elektronische Regeleinrichtung (9) einen Differenzbilder zwischen den beiden Photodetektorsignalen aufweist.

10. Einrichtung nach einem der Ansprüche 6 bis 9, dadurch gekennzeichnet, daß die frequenzselektive optische Anordnung (M1,M2,M3,M4) mit der Umgebungsluft kommuniziert, sodaß die Referenzfrequenz automatisch in Abhängigkeit von der Brechzahl der Umgebungsluft variiert.

11. Einrichtung nach einem der Ansprüche 2 bis 5 und einem der Ansprüche 6 bis 10, dadurch gekennzeichnet, daß der optische Frequenzdiskriminator (2) und die frequenzselektive optische Anordnung für die elektronische Regelung im wesentlichen von ein und denselben optischen Bauteilen (M1,M2,M3,M4) gebildet sind.

12. Einrichtung nach einem der Ansprüche 6 bis 11, dadurch gekennzeichnet, daß eine elektronische Auswertschaltung (3) das zur elektronischen Regelung der Trägerfrequenz des Halbleiterlasers (LD) auf die Referenzfrequenz vorgesehene elektrische Regelsignal analysiert und daraus die Geschwindigkeit, den Verschiebeweg und/oder die Entfernung des Meßobjektes ermittelt.

13. Einrichtung nach einem der Ansprüche 1 bis 12, dadurch gekennzeichnet, daß die Sendefrequenz des Halbleiterlasers (LD) gezielt, vorzugsweise periodisch verändert wird.

14. Einrichtung nach Anspruch 13, dadurch gekennzeichnet, daß die Änderungsfrequenz der vorzugsweise zeitlich sägezahnförmigen Sendefrequenz im kHz-Bereich und der Frequenzhub im Bereich von 1-100 GHz und darüber liegt.

15. Einrichtung nach einem der Ansprüche 6 bis 12 und einem der Ansprüche 13 bis 14, dadurch gekennzeichnet, daß die Referenzfrequenz der frequenzselektiven optischen Anordnung (M1,M2,M3,M4) gezielt, vorzugsweise periodisch, veränderbar ist.

16. Einrichtung nach Anspruch 15, dadurch gekennzeichnet, daß zur Referenzfrequenzverstellung elektrooptische Elemente oder die geometrische Lage von Bauteilen (M4) der optischen Anordnung verändernde Elemente, insbesondere piezoelektrische Elemente vorgesehen sind.

17. Einrichtung nach einem der Ansprüche 1 bis 16, dadurch gekennzeichnet, daß das aus dem Halbleiterlaser (LD) stammende Laserlicht zwischen Halbleiterlaser (LD) und Meßobjekt (1) durch eine Frequenzverschiebeeinrichtung (AOM) geführt ist.

18. Einrichtung nach Anspruch 17, dadurch gekennzeichnet, daß die Frequenzverschiebeeinrichtung ein akusto-optischer Modulator (AOM) ist.

**19.** Einrichtung nach Anspruch 18, dadurch gekennzeichnet, daß die Frequenzverschiebung bei einmaligem Durchlauf zwischen 10 und 100 MHz liegt.

**20.** Einrichtung nach einem der Ansprüche 1 bis 19, dadurch gekennzeichnet, daß der auf das Meßobjekt (1) gerichtete Strahl leicht konvergent aus der Sende- und Empfangsoptik (L1,L2) austritt.

**21.** Einrichtung nach Anspruch 20 und einem der Ansprüche 17 bis 19, dadurch gekennzeichnet, daß die Frequenzverschiebeeinrichtung (AOM) im Zwischenfokus des konvergenten Ausgangsstrahles angeordnet ist.

**22.** Einrichtung nach einem der Ansprüche 1 bis 21, dadurch gekennzeichnet, daß im Strahlengang zwischen dem Halbleiterlaser (LD) und dem Meßobjekt (1) ein gegebenenfalls geregeltes Abschwächglied angeordnet ist, das sicherstellt, daß weniger als $10^{-3}$ der Ausgangsleistung des Halbleiterlases in diesen zurückgekoppelt wird.

**23.** Einrichtung nach einem der Ansprüche 1 bis 22, dadurch gekennzeichnet, daß im Strahlengang des aus dem Halbleiterlaser (LD) austretenden Laserlichts ein Strahlteiler (BS1) angeordnet ist, der einen Teil des Laserlichts zur Detektoreinrichtung (2,PD1,3) abzweigt.

**24.** Einrichtung nach einem der Ansprüche 1 bis 23, dadurch gekennzeichnet, daß die Detektoreinrichtung eine elektronische Auswerteinrichtung (3) zur Ermittlung und Anzeige von Geschwindigkeit und/oder Abstand des gemessenen Objekts aus der erfaßten Modulationsfrequenz des frequenzmodulierten Laserlichts und gegebenenfalls aus weiteren Parametern wie beispielsweise der Brechzahl des Umgebungsmediums, der Treiberfrequenz des akusto-optischen Modulators und/oder der Modulationsfrequenz der Sendefrequenz umfaßt.

**25.** Einrichtung nach Anspruch 24, dadurch gekennzeichnet, daß die Auswerteinrichtung einen Spektrumanalysator (SA) aufweist.

**Claims**

**1.** Device for non-contact measurement of speed, displacement travel and/or distance of a reflecting measurement object, comprising a laser (LD), in particular a semiconductor laser, as a light source, in which the level of light intensity in the laser resonator influences the optical length thereof, a transmitting and receiving optical system (L1, L2) for directing laser light from the laser (LD) onto the measurement object (1) and for feeding back a part of the laser light reflected by the measurement object (1) into the laser resonator, and a detector means for detecting and analyzing the laser light which is emitted by the laser (LD) and which is modulated in dependency on the laser light feedback from the measurement object (1) into the laser resonator, characterized in that the detector means has at least one means (2, PD1, 3) for detecting the modulation frequency of the frequency modulation of the laser light emitted by the laser (LD) and frequency-modulated by the backscattering signal.

**2.** Device according to claim 1, characterized in that the means (2, PD1, 3) for monitoring the modulation frequency has an optical arrangement, preferably an optical frequency discriminator (2), for producing an output radiation which is amplitude-modulated with the modulation frequency of the frequency modulation and which is detected by at least one photodetector (PD1).

**3.** Device according to claim 2, characterized in that the frequency discriminator (2) is an optical resonator which is preferably operated in the reflection mode, in particular a ring resonator (M1, M2, M3, M4), wherein the carrier frequency of the frequency-modulated laser light lies within the resonance line width, preferably beside the resonance centre frequency of a resonance of the ring resonator.

**4.** Device according to claim 3, characterized in that the resonator has dielectric mirrors (M1, M2, M3, M4).

**5.** Device according to one of claims 2 through 4, characterized in that the discriminator characteristic width (resonance line width) lies in the 10-1000 MHz-range.

**6.** Device according to one of claims 1 through 5, characterized in that it has a frequency-selective optical arrangement (M1, M2, M3, M4) for producing at least one optical regulating signal which reflects the instantaneous position of the frequency of the laser light with repsect to a reference frequency, at least one photodetector (DP2, DP3) for conversion of the optical regulating signal into an electrical regulating signal and an electronic regulating means (9) which in dependence on said electrical regulating signal regulates or stabilises the carrier frequency of the semiconductor laser (LD) to the reference frequency.

**7.** Device according to claim 6, characterized in that the frequency-selective optical arrangement is an optical resonator, preferably a ring resonator (M1, M2, M3, M4) which is operated in the transmission mode and the resonance frequency of which defines the reference frequency.

8. Device according to claim 7, characterized in that the resonance centre frequency of the resonator (M1, M2, M3, M4) depends on polarisation of the light, wherein the resonance centre frequencies for two mutually perpendicular polarisation effects are disposed in side-by-side relationship and each within the resonance line width of the respective other polarisation effect, and that disposed downstream of the resonator (M1, M2,M3, M4) is a polarisation beam splitter (6), a beam splitter with downstream-disposed polarisers or the like for dividing the optical regulating signal into two beam portions of different polarisation, wherein the beam portions are detected by separate photodetectors (DP2, DP3).

9. Device according to claim 8, characterized in that the electronic regulating means (9) has a means for forming a difference between two photodetector signals.

10. Device according to one of claims 6 through 9, characterized in that the frequency-selective optical arrangement (M1, M2, M3, M4) communicates with the ambient air so that the reference frequency varies automatically in dependence on the refractive index of the ambient air.

11. Device according to one of claims 2 through 5 and one of claims 6 through 10, characterized in that the optical frequency discriminator (2) and the frequency-selective optical arrangement for electronic regulation are formed essentially by one and the same optical components (M1, M2, M3, M4).

12. Device according to one of claims 6 through 11, characterized in that an electronic evaluation circuit (3) analyses the electrical regulating signal provided for electronic regulation of the carrier frequency of the semiconductor laser (LD) to the reference frequency and ascertains therefrom the speed, the displacement travel and/or the distance of the measurement object.

13. Device according to one of claims 1 through 12, characterized in that the transmission frequency of the semiconductor laser (LD) is varied deliberately, preferably periodically.

14. Device according to claim 13, characterized in that the frequency of variation in the transmission frequency which is preferably of a sawtooth form in respect of time is in the kHz-range and the frequency deviation is in the range of 1-100 GHz and above.

15. Device according to one of claims 6 through 12 and one of claims 13 through 14, characterized in that the reference frequency of the frequency-selective optical arrangement (M1, M2, M3, M4) is variable deliberately, preferably periodically.

16. Device according to claim 15, characterized in that provided for reference frequency adjustment are electro-optical elements or elements which vary the geometrical position of components (M4) of the optical arrangement, in particular piezoelectric elements.

17. Device according to one of claims 1 through 16, characterized in that the laser light from the semiconductor laser (LD) is passed through a frequency shift means (AOM) between the semiconductor laser (LD) and the measurement object (1).

18. Device according to claim 17, characterized in that the frequency shift means is an acousto-optical modulator (AOM).

19. Device according to claim 18, characterized in that the frequency shift is between 10 and 100 MHz, when the laser light passes once through the frequency shift means.

20. Device according to one of claims 1 through 19, characterized in that the beam which is directed onto the measurement object (1) issues in a slightly convergent condition from the transmitting and receiving optical system (L1, L2).

21. Device according to claim 20 and one of claims 17 through 19, characterized in that the frequency shift means (AOM) is arranged at the intermediate focus of the convergent output beam.

22. Device according to one of claims 1 through 21, characterized in that arranged in the beam path between the semiconductor laser (LD) and the measurement object (1) is a possibly regulated attenuating member which ensures that less than $10^{-3}$ of the output power of the semiconductor laser is fed back into same.

23. Device according to one of claims 1 through 22, characterized in that arranged in the beam path of the laser light issuing from the semiconductor laser (LD) is a beam splitter (BS1) which branches off a part of the laser light to the detector means (2, PD1, 3).

24. Device according to one of claims 1 through 23, characterized in that the detector means includes an electronic evaluation means (3) for ascertaining and displaying speed and/or distance of the object being measured from the detected modulation frequency of the frequency-modulated laser light and possibly from further parameters, such as for example the refractive index of the ambient medium, the driver frequency of the acousto-optical modulator and/or the modulation frequency of the transmission frequency.

25. Device according to claim 24, characterized in that the evaluation means has a spectrum analyser (SA).

## Revendications

1. Système pour la mesure sans contact de la vitesse, du déplacement et/ou de l'éloignement, d'un objet de mesure réfléchissant, comprenant un laser (LD) en particulier un laser semi-conducteur comme source de lumière, dans lequel l'intensité lumineuse dans le résonateur laser influence sa longueur optique, une optique de réception et d'émission (L1, L2) pour diriger la lumière laser provenant du laser (LD) sur l'objet de mesure (1) et pour réinjecter une partie de la lumière laser réfléchie par l'objet de mesure (1) dans le résonateur laser, et un dispositif détecteur pour détecter et analyser la lumière laser émise par le laser (LD), lumière qui est modulée en fonction de la réinjection de lumière laser depuis l'objet de mesure (1) dans le résonateur laser, caractérisé en ce que le dispositif détecteur présente au moins un dispositif (2, PD1, 3) destiné à détecter la fréquence de modulation de la lumière laser émise par le laser (LD) et modulée en fréquence par le signal rétrodiffusé.

2. Système selon la revendication 1, caractérisé en ce que le dispositif (2, PD1, 3) de détection de la fréquence de modulation présente un dispositif optique, de préférence un discriminateur optique de fréquences (2), destiné à produire un rayonnement de sortie modulé en amplitude avec la fréquence de modulation de la modulation en fréquence, lequel rayonnement est détecté par au moins un photodétecteur (PD1).

3. Système selon la revendication 2, caractérisé en ce que le discriminateur de fréquences (2) est de préférence un résonateur optique utilisé en réflexion, en particulier un résonateur annulaire (M1, M2, M3, M4), la fréquence porteuse de la lumière laser modulée en fréquence étant située à l'intérieur de la largeur de bande de résonance, de préférence à côté de la fréquence médiane d'une résonance du résonateur annulaire.

4. Système selon la revendication 3, caractérisé en ce que le résonateur présente des miroirs diélectriques (M1, M2, M3, M4).

5. Système selon l'une quelconque des revendications 2 à 4, caractérisé en ce que la largeur de caractéristique du résonateur (largeur de bande de résonance) est située dans le domaine 10-1000 MHz.

6. Système selon l'une quelconque des revendications 1 à 5, caractérisé en ce qu'il présente un dispositif optique (M1, M2, M3, M4) sélectif en fréquence pour produire au moins un signal optique de régulation représentatif de la position momentanée de la lumière laser par rapport à une fréquence de référence, au moins un photodétecteur (DP2, DP3) pour transformer le signal optique de régulation en un signal électrique de régulation, et un dispositif de régulation électronique (9) qui, en fonction de ce signal électrique de régulation, règle ou stabilise la fréquence porteuse du laser semi-conducteur (LD) à la fréquence de référence.

7. Système selon la revendication 6, caractérisé en ce que le dispositif optique sélectif en fréquence est un résonateur optique, de préférence un résonateur annulaire (M1, M2, M3, M4) utilisé en transmission, dont la fréquence de résonance définit la fréquence de référence.

8. Système selon la revendication 7, caractérisé en ce que la fréquence médiane de résonance du résonateur (M1, M2, M3, M4) dépend de la polarisation de la lumière, les fréquences médianes de résonance pour deux polarisations perpendiculaires l'une à l'autre se trouvant l'une à côté de l'autre et chacune à l'intérieur de la largeur de bande de résonance de l'autre polarisation, et en ce que le résonateur (M1, M2, M3, M4) est suivi d'un séparateur de rayons à polarisation (6), d'un séparateur de rayons suivi de polariseurs, ou analogue, pour décomposer le signal optique de régulation en deux rayons partiels, les rayons partiels étant détectés par des photodétecteurs distincts (DP2, DP3).

9. Dispositif selon la revendication 8, caractérisé en ce que le dispositif électronique de régulation (9) présente un formateur de différence entre les deux signaux des photodétecteurs.

10. Système selon l'une quelconque des revendications 6 à 9, caractérisé en ce que le dispositif optique (M1, M2, M3, M4) sélectif en fréquence communique avec l'air ambiant, de sorte que la fréquence de référence varie automatiquement en fonction de l'indice de réfraction de l'air ambiant.

11. Système selon l'une quelconque des revendications 2 à 5 et l'une quelconque des revendications 6 à 10, caractérisé en ce que le discriminateur optique de fréquences (2) et le dispositif optique sélectif en fréquence pour la régulation électronique sont formés pour l'essentiel des mêmes composants optiques (M1, M2, M3, M4).

12. Système selon l'une quelconque des revendications 6 à 11, caractérisé en ce qu'un circuit d'exploitation électronique (3) analyse le signal de régulation prévu pour la régulation électronique de la fréquence porteuse du laser semi-conducteur (LD) sur la fréquence de référence, et détermine à partir de là la vitesse, le déplacement et/ou l'éloignement de l'objet de mesure.

13. Système selon l'une quelconque des revendications 1 à 12, caractérisé en ce que la fréquence d'émission du laser semi-conducteur (LD) est modifiée à dessein, de préférence périodiquement.

14. Système selon la revendication 13, caractérisé en ce que la fréquence de variation de la fréquence d'émission de préférence en dents de scie au cours du temps se trouve dans le domaine des kHz, et le décalage de fréquence se trouve dans le domaine de 1-100 GHz et plus.

15. Système selon l'une quelconque des revendications 6 à 12 et l'une des revendications 13 à 14, caractérisé en ce que la fréquence de référence du dispositif optique (M1, M2, M3, M4) sélectif en fréquence peut être modifiée à dessein, de préférence périodiquement.

16. Système selon la revendication 15, caractérisé en ce que, pour modifier la fréquence de référence, des éléments optoélectroniques ou des éléments modifiant la position géométrique de composants (M4) du dispositif optique, en particulier des éléments piézo-électriques, sont prévus.

17. Système selon l'une quelconque des revendications 1 à 16, caractérisé en ce que la lumière provenant du laser semi-conducteur (LD) passe entre le laser semi-conducteur (LD) et l'objet de mesure (1) à travers un dispositif de déplacement de fréquence (AOM).

18. Système selon la revendication 17, caractérisé en ce que le dispositif de déplacement de fréquence est un modulateur opto-acoustique (AOM).

19. Système selon la revendication 18, caractérisé en ce que le déplacement de fréquence, pour un seul passage, vaut entre 10 et 100 MHz.

20. Système selon l'une quelconque des revendications 1 à 19, caractérisé en ce que le rayon dirigé sur l'objet de mesure (1) sort légèrement convergent de l'optique d'émission et de réception (L1, L2).

21. Système selon la revendication 20 et l'une quelconque des revendications 17 à 19, caractérisé en ce que le dispositif de déplacement de fréquence (AOM) est placé au foyer intermédiaire du faisceau convergent de sortie.

22. Système selon l'une quelconque des revendications 1 à 21, caractérisé en ce que, sur le chemin optique entre le laser semi-conducteur (LD) et l'objet de mesure (1), est placé un élément d'affaiblissement, le cas échéant réglé, qui assure que moins de $10^{-3}$ de la puissance de sortie du laser semi-conducteur y est réinjecté.

23. Système selon l'une quelconque des revendications 1 à 22, caractérisé en ce que, sur le chemin optique de la lumière laser sortant du laser semi-conducteur (LD), est placé un séparateur de rayons (BS1) qui dévie une partie de la lumière laser en direction du dispositif détecteur (2, PD1, 3).

24. Système selon l'une quelconque des revendications 1 à 23, caractérisé en ce que le dispositif détecteur comprend un dispositif électronique d'exploitation (3) destiné à déterminer et afficher la vitesse et/ou la distance de l'objet mesuré à partir de la fréquence de modulation détectée de la lumière laser modulée en fréquence et, le cas échéant, d'autres paramètres comme par exemple l'indice de réfraction du milieu ambiant, la fréquence motrice du modulateur opto-acoustique et/ou la fréquence de modulation de la fréquence d'émission.

25. Système selon la revendication 24, caractérisé en ce que le dispositif d'exploitation présente un analyseur de spectre (SA).

Fig. 1

Fig. 2

EP 0 479 999 B1